Europäisches Patentamt

European Patent Office

Office européen des brevets

(11) Veröffentlichungsnummer: **0 242 640**
**A1**

## (12) EUROPÄISCHE PATENTANMELDUNG

(21) Anmeldenummer: 87104671.0

(22) Anmeldetag: 30.03.87

(51) Int. Cl.4: **G01R 15/12**

(30) Priorität: 11.04.86 DE 3612237

(43) Veröffentlichungstag der Anmeldung:
28.10.87 Patentblatt 87/44

(84) Benannte Vertragsstaaten:
AT CH DE FR GB IT LI

(71) Anmelder: **Blaupunkt-Werke GmbH**
**Robert-Bosch-Strasse 200**
**D-3200 Hildesheim(DE)**

(72) Erfinder: **Bothe, Michael**
**An der Kirche 8**
**D-3388 Bad Harzburg(DE)**
Erfinder: **Black, Karl-Heinz**
**Kunibertstrasse 4a**
**D-3200 Hildesheim(DE)**
Erfinder: **Diethelm, Otto**
**Kemmer Strasse 3**
**D-3207 Adlum(DE)**

(74) Vertreter: **Eilers, Norbert, Dipl.-Phys.**
**Blaupunkt-Werke GmbH**
**Robert-Bosch-Strasse 200**
**D-3200 Hildesheim(DE)**

(54) Anordnung zur Überwachung von Spannungen und/oder Strömen.

(57) Bei einer Anordnung zur Überwachung von Spannungen und/oder Strömen in einem Schaltnetzteil eines nachrichtentechnischen Gerätes, vorzugsweise eines Fernsehempfängers, sind die zu überwachenden Spannungen und/oder von den zu überwachenden Strömen abhängige Spannungen über einen Multiplexer einem Analog/Digital-Wandler zuführbar. Der Analog/Digital-Wandler ist ausgangsseitig mit einem Mikroprozessor verbunden, an den eine Anzeigevorrichtung angeschlossen ist. Im Mikroprozessor ist ein Programm abgelegt, welches die Spannungen in zyklischer Folge mit gespeicherten Grenzwerten vergleicht und das Vergleichsergebnis zur Anzeige bringt.

Fig.1

## Anordnung zur Überwachung von Spannungen und/oder Strömen

Die Erfindung geht aus von einer Anordnung nach der Gattung des Hauptanspruchs.

Zur Strom-und Spannungsüberwachung in Schaltnetzteilen von Fernsehgeräten sind Schaltungen bekannt, bei welchen jeweils eine Leuchtdiode aufleuchtet, wenn die betreffende Ausgangsspannung vorhanden ist. Weitere bekannte Schaltungsanordnungen sehen für zu überwachende Spannungen und Ströme Fensterdiskriminatoren vor, wodurch nicht nur das Vorhandensein als solches angezeigt wird, sondern auch, ob die zu überwachende Größe innerhalb eines Toleranzbereichs liegt. Diese bekannten Schaltungen sind jedoch recht aufwendig und wenig anpassungsfähig an verschiedene Schaltnetzteile.

Die erfindungsgemäße Anordnung mit den kennzeichnenden Merkmalen des Hauptanspruchs hat demgegenüber den Vorteil, daß sie leicht an verschiedene Schaltnetzteile durch Änderung der eingegebenen Grenzwerte angepaßt werden kann. Weitere Vorteile sind darin zu sehen, daß die Schaltung durch Verwendung von wenigen, meist digitalen Bauelementen störunempfindlich und preiswert in der Herstellung ist.

Durch die in den Unteransprüchen aufgeführten Maßnahmen sind vorteilhafte Weiterbildungen und Verbesserungen der im Hauptanspruch angegebenen Erfindung möglich. Außer für Fernsehempfänger ist die erfindungsgemäße Anordnung auch für andere nachrichtentechnische Geräte geeignet, wie beispielsweise Monitore und Datensichtgeräte.

Ein Ausführungsbeispiel der Erfindung ist in der Zeichnung an Hand mehrerer Figuren dargestellt und in der nachfolgenden Beschreibung näher erläutert. Es zeigt:

Fig. 1 ein Blockschaltbild eines Ausführungsbeispiels und eines an sich bekannten zu überwachenden Schaltnetzteils und

Fig. 2 ein Flußdiagramm eines im Mikroprozessor gespeicherten Programms.

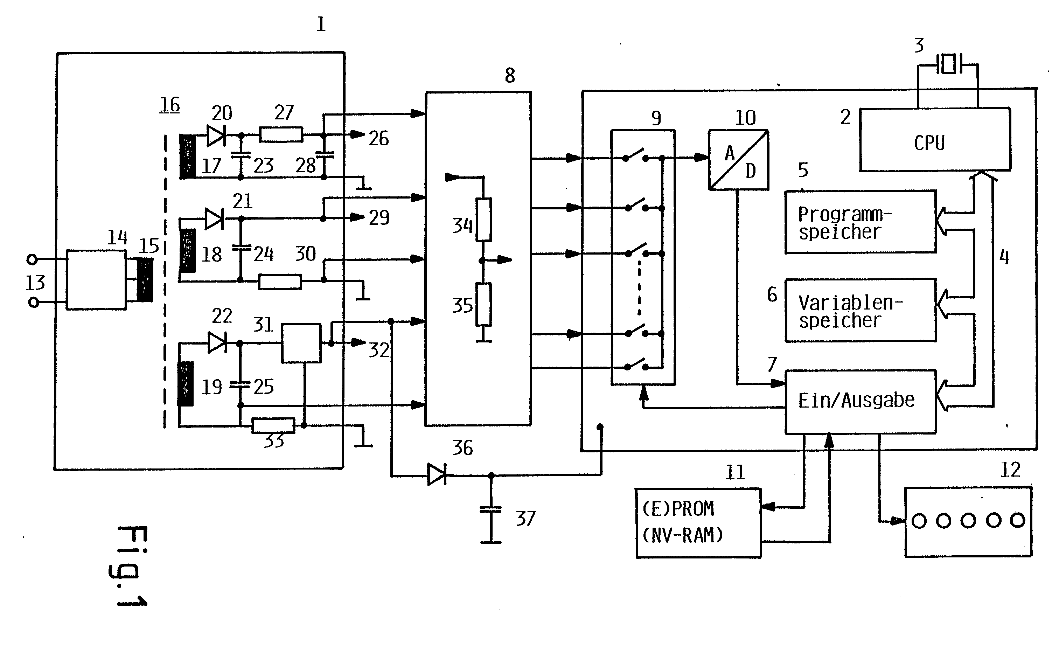

Bei der Anordnung nach Fig. 1 werden Spannungen und Ströme eines Schaltnetzteils 1 mit Hilfe eines Mikroprozessors 2 bis 7 überwacht, an den das Schaltnetzteil 1 über eine Anpassungsschaltung 8, einen Multiplexer 9 und einen Analog/Digital-Wandler 10 angeschlossen ist. Grenzwerte sind in einem Nur-Lese Speicher 11 abgelegt. Eine Anzeigevorrichtung 12 dient dazu, unzulässige Abweichungen der Spannungen und Ströme des Schaltnetzteils 1 bzw. den ordnungsgemäßen Betriebszustand anzuzeigen.

Den Eingangsanschlüssen 13 des Schaltnetzteils 1 wird Netzspannung zugeführt, welche in einer primärseitigen Schaltung 14 gleichgerichtet und in eine Wechaselspannung höherer Frequenz umgewandelt wird, mit der die Primärwicklung 15 eines Transformators 16 versorgt wird. Sekundärwicklungen 17, 18, 19 des Transformators 16 erzeugen verschieden hohe Spannungen, welche mit Dioden 20, 21, 22 gleichgerichtet werden. Zur Glättung der gleichgerichteten Wechselspannungen sind Ladekondensatoren 23, 24, 25 vorgesehen. Je nach Erfordernissen der übrigen Schaltungen des Gerätes sind die einzelnen Spannungsquellen des Schaltnetzteils recht unterschiedlich auszulegen, beispielsweise für relativ hohe Spannungen von einigen 100 V oder für geringe Spannungen von beispielsweise 5 V. Der abzugebende Strom kann auch sehr verschieden sein, ebenso wie die Anforderungen an Siebung und Stabilität der jeweiligen Spannung. Bei dem in Fig. 1 dargestellten Schaltnetzteil 1 sind nur einige dieser Möglichkeiten beispielhaft dargestellt, so ist die am Ausgang 26 anstehende Spannung durch ein Siebglied 27, 28 gesiebt, während die Spannung am Ausgang 26 direkt vom Ladekondensator 24 weitergeleitet wird. Beide Spannungen werden außer zu den jeweiligen nicht dargestellten Verbrauchern auch zur Anpassungsschaltung 8 geleitet. Während bei der Spannungsquelle mit dem Ausgang 26 keine Strommessung vorgesehen ist, wird bei der Spannungsquelle mit dem Ausgang 29 über einen Widerstand 30 eine dem Strom proportionale Spannung abgegriffen und ebenfalls zur Anpassungsschaltung 8 geführt.

Schließlich ist bei dem in Fig. 1 dargestellten Schaltnetzteil 1 noch eine Spannungsquelle mit einem Spannungsregler 31 dargestellt, deren Ausgang 32 ebenfalls zur Überwachung mit der Anpassungsschaltung 8 verbunden ist. Auch bei dieser Spannungsquelle ist ein Strommeßwiderstand 33 vorgesehen, dessen Spannungsabfall einem Eingang der Anpassungsschaltung 8 zugeleitet wird.

Die Anpassungsschaltung 8 paßt die Werte der zugeführten Spannungen an den Eingangsspannungsbereich des Analog/Digital-Wandlers 10 an, so daß einerseits keine Überschreitung dieses Bereichs erfolgt und andererseits möglichst viele Quantisierungsstufen genutzt werden, um Quantisierungsfehler gering zu halten. Da viele der zu überwachenden Spannungen größer als die maximale Eingangsspannung des Analog/Digital-Wandlers 10 sind, ist beispielhaft in das Symbol der Anpassungsschaltung 8 ein aus zwei Widerständen 34, 35 bestehender Spannungsteiler eingezeichnet.

Es können jedoch auch andere Anpassungen vorgenommen werden, die möglicherweise sogar aktive Schaltungen erfordern. So sind beispielsweise die an den Widerständen 30, 33 abgegriffenen Spannungen gegenüber Massepotential negativ. Mit Hilfe einer einfachen Transistorschaltung kann eine Polaritätsumkehr vorgenommen werden, sofern der Analog/Digital-Wandler 10 nicht Werte beider Polaritäten verarbeiten kann. In diesem Zusammenhang sei noch erwähnt, daß die meisten in der Praxis verwendeten Schaltnetzteile auch negative Ausgangsspannungen erzeugen.

Der Mikroprozessor verfügt über eine Zentraleinheit 2, welcher zur Takterzeugung ein Quarz 3 zugeordnet ist. Die Zentraleinheit ist über ein Bussystem 4 mit einem Programmspeicher 5, einem Variablenspeicher 6 und eine Ein/Ausgabe-Einheit 7 verbunden. Diese Darstellung des Mikroprozessors ist ebenfalls nur beispielhaft. Es sind verschiedene Formen von Mikroprozessoren erhältlich, beispielsweise solche, bei denen der Mikroprozessor zusammen mit dem Multiplexer 9 und dem Analog/Digital-Wandler 10 als integrierte Schaltung ausgeführt ist.

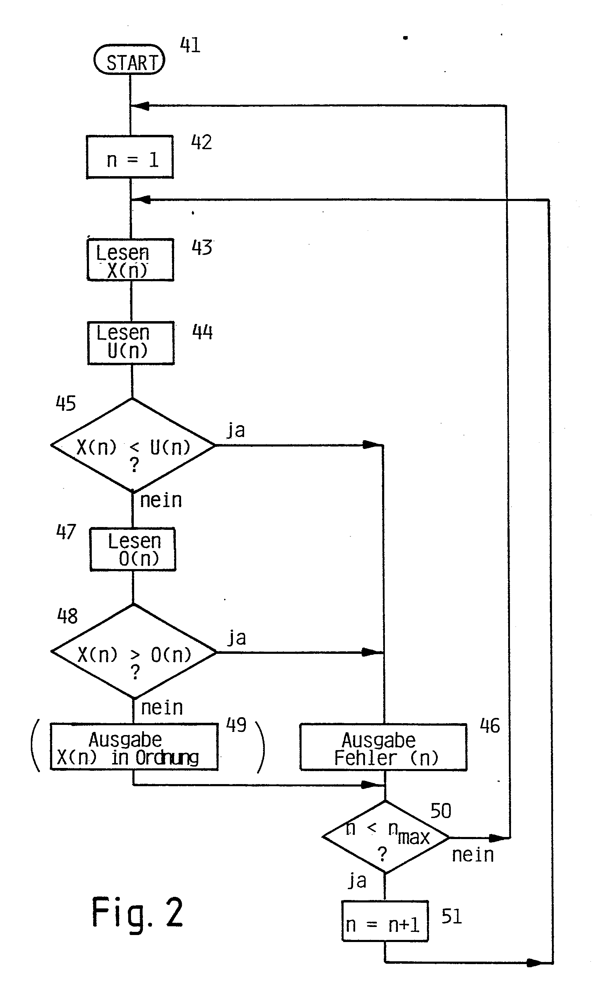

Nach dem im Programmspeicher 5 abgelegten Programm, welches später im Zusammenhang mit Fig. 2 näher erläutert wird, werden in zyklischer Folge die Schalter des Multiplexers 9 geschlossen und somit die Ausgänge der Anpassungsschaltung 8 abgefragt. Die damit erhaltenen Werte werden in digitaler Form über die Ein/Ausgabe-Einheit 7 zur Zentraleinheit 2 geleitet. Dort werden sie mit Grenzwerten verglichen, welche aus einem programmierbaren Nur-Lese-Speicher 11 entnommen werden. Je nach Ergebnis des Vergleichs erfolgt eine Anzeige einer Anzeigevorrichtung 12, welche eine Reihe von Leuchtdioden umfassen oder als Flüssigkristallzelle ausgebildet sein kann.

Für die Speicherung der Grenzwerte eignen sich auch andere Speicher, beispielsweise nichtflüchtige Speicher (NV-RAMs), in welche die Grenzwerte elektrisch eingeschrieben werden können. Damit wird ermöglicht, daß erfindungsgemäße Anordnungen einschließlich der Bestückung mit dem NV-RAM hergestellt und anschließend in einem "Lernvorgang" an ihren speziellen Verwendungszweck angepaßt werden können.

Ferner ist es möglich, den Programmspeicher und den Speicher für die Grenzwerte zusammenzufassen, wobei in Abhängigkeit von der erforderlichen Stückzahl verschiedene Technologien anwendbar sind. Bei Verwendung eines NV-RAMs können auch die Fehlermeldungen, gegebenenfalls einschließlich der Reihenfolge ihres Auftretens, bei Ausfall des Fernsehempfängers gespeichert werden. Es können dann Rückschlüsse auf die Vorgänge vor dem Ausfall gezogen werden, was möglicherweise die Fehlersuche erleichtert.

Zu den vom Mikroprozessor überwachten Spannungen kann auch die Betriebsspannung des Mikroprozessors selbst gehören. Dieses kann unter anderem dann sinnvoll sein, wenn ein NV-RAM zur Speicherung von Fehlermeldungen verwendet wird und im Falle des Ausbleibens der Betriebsspannung des Mikroprozessors noch Daten ordnungsgemäß in das NV-RAM geschrieben werden sollen. Um dieses zu ermöglichen, kann dem Mikroprozessor die Betriebsspannung über eine Diode 36 und einen Kondensator 37 zugeführt werden, so daß nach Ausfall der Betriebsspannung am Ausgang 32 des Schaltnetzteils 1 kurzzeitig noch Betriebsspannung für den Mikroprozessor zur Verfügung steht.

Das in Fig. 2 dargestellte Programm wird bei 41 automatisch beim Einschalten des Fernsehempfängers gestartet. Bei 42 wird eine Zählvariable n auf den Wert 1 gesetzt. Die Zählvariable kennzeichnet die Eingänge des Multiplexers 9 (Fig. 1) sowie die Adressen des oberen Grenzwertes 0 und des unteren Grenzwertes U.

Im Programmschritt 43 erfolgt das Lesen der zu überwachenden Größe X(n) dadurch, daß der jeweilige Wert für n dem Multiplexer 9 zugeführt und anschließend das Ausgangssignal des Analog/Digital-Wandlers 10 an dem entsprechenden Eingangsregister der Ein/Ausgabe-Einheit 7 abgelesen und in die Zentraleinheit 2 übernommen wird.

Bei 44 erfolgt in ähnlicher Weise das Lesen des unteren Grenzwertes U(n). Im Programmschritt 45 wird festgestellt, ob X(n) kleiner als U(n) ist. Ist dies der Fall, so wird bei 46 die Ausgabe der Fehlermeldung an die Anzeigevorrichtung 12 (Fig 1) veranlaßt. Dabei kann im einfachsten Fall die nte Leuchtdiode angesteuert werden. Es ist jedoch auch im Falle der Verwendung einer aufwendigeren Anzeigevorrichtung, beispielsweise einer Flüssigkristallzelle möglich, hierbei den Zählwert n in einen verständlichen Ausdruck, beispielsweise "U1 zu hoch" umzuwandeln.

Wurde bei der Verzweigung 45 festgestellt, daß der zu messende Wert oberhalb des Grenzwertes oder gleich dem Grenzwert ist, so wird im Programmschritt 47 der obere Grenzwert 0(n) aus dem Speicher gelesen. Bei der Verzweigung 48 wird festgestellt, ob X(n) größer als 0(n) ist. Ist dieses der Fall, so wird bei 46 eine Fehlermeldung ausgegeben. Anderenfalls liegt der zu überwachende Wert X(n) zwischen den Grenzwerten und ist somit in Ordnung, was bei 49 gegebenenfalls angezeigt werden kann.

Nach den Programmschritten 46 bzw. 49 wird bei der Verzweigung 50 geprüft, ob n noch kleiner als nmax ist, wobei nmax die Anzahl der Eingänge des Multiplexers 9 (Fig. 1) darstellt. Ist nmax erreicht, so wird die Zählvariable n erneut auf 1 gesetzt. Ist n jedoch noch kleiner als nmax, wird n bis 51 um 1 erhöht und das Programm mit der neuen Zählvariablen wiederholt.

Zur Anpassung an verschiedene Netzgeräte kann jeweils ein an ein Netzgerät angepaßtes Programm im Speicher 5 abgelegt werden. Da sich jedoch im wesentlichen die Grenzwerte ändern, können auch lediglich die Grenzwerte entsprechend dem jeweiligen Netzgerät gewählt werden. Sollte ein Netzgerät nicht so viele überwachungsbedürftige Spannungen bzw. Ströme aufweisen, wie Eingänge am Multiplexer 9 vorgesehen sind, so können die Eingänge ohne weiteres offengelassen werden, wenn in den für die Grenzwerte vorgesehenen Speicher unter der entsprechenden Adresse der Wert 0 abgelegt wird.

## Ansprüche

1. Anordnung zur Überwachung von Spannungen und/oder Strömen in einem Schaltnetzteil eines nachrichtentechnischen Gerätes, vorzugsweise eines Fernsehempfängers, dadurch gekennzeichnet,
daß die zu überwachenden Spannungen und/oder von den zu überwachenden Strömen abhängige Spannungen über einen Multiplexer (9) einem Analog/Digital-Wandler (10) zuführbar sind,
daß der Analog/Digital-Wandler (10) ausgangsseitig mit einem Mikroprozessor (2 bis 7) verbunden ist,
daß an den Mikroprozessor (2 bis 7) eine Anzeigevorrichtung (12) angeschlossen ist und
daß im Mikroprozessor (2 bis 7) ein Programm abgelegt ist, welches die Spannungen in zyklischer Folge mit gespeicherten Grenzwerten vergleicht und das Vergleichsergebnis zur Anzeige bringt.

2. Anordnung nach Anspruch 1, dadurch gekennzeichnet,
daß eine Anpassungsschaltung (8) vorgesehen ist, welche die zu überwachenden Spannungen und/oder von den zu überwachenden Strömen abhängige Spannungen an den Analog/Digital-Wandler (10) anpaßt.

3. Anordnung nach Anspruch 1, dadürch gekennzeichnet,
daß zur Speicherung von Grenzwerten ein programmierbarer Nur-Lese-Speicher (11) vorgesehen ist.

4. Anordnung nach Anspruch 1, dadurch gekennzeichnet,
daß zur Speicherung von Grenzwerten ein nichtflüchtiger Speicher (NV-RAM) (11) vorgesehen ist.

5. Anordnung nach Anspruch 4, dadurch gekennzeichnet,
daß im nichtflüchtigen Speicher (11) außer Grenzwerten auch Fehlermeldungen speicherbar sind.

Fig.1

Fig. 2

Europäisches Patentamt

**EUROPÄISCHER RECHERCHENBERICHT**

Nummer der Anmeldung

EP 87 10 4671

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int. Cl.4) |
|---|---|---|---|
| Y | ELECTRONIQUE INDUSTRIELLE, Nr. 47, 15. Februar 1983, Seiten 55-57, Paris, FR; A. FABREGUE: "Un voltmètre large bande permet la mesure de différents paramètres d'une tension alternative" * Figur 2 * | 1 | G 01 R 15/12 |
| | --- | | |
| Y | DE-A-2 504 316 (PRECISOR-MESSTECHNIK INGENIEURBÜRO ULRICH FÜHRER) * Seiten 7-9; Figur * | 1 | |
| | --- | | |
| Y | EP-A-0 114 536 (SOLOMAT S.A.) * Seiten 21-22, Patentansprüche; Abbildung 1 * | 1 | |
| | ----- | | RECHERCHIERTE SACHGEBIETE (Int. Cl.4) |
| | | | G 01 R |

Der vorliegende Recherchenbericht wurde für alle Patentansprüche erstellt.

| Recherchenort | Abschlußdatum der Recherche | Prüfer |
|---|---|---|
| DEN HAAG | 27-07-1987 | KUSCHBERT D.E. |